# EUROPEAN PATENT APPLICATION

(11) **EP 3 528 275 A2**
(43) Date of publication of application: **21.08.2019**
(21) Application number: 19153246.4
(22) Date of filing: 23.01.2019
(51) Int. Cl.: H01J 37/04, G01R 31/28

(54) **METHOD AND APPARATUS OF MEASURING HIGH-SPEED ELECTRICAL ACTIVITY WITHIN INTEGRATED CIRCUITS USING CHARGED PARTICLE BEAMS**

(30) Priority: 25.01.2018 US 201862622065 P
(71) Applicant: FEI Company, Hillsboro, OR 97124-5793 (US)
(72) Inventor: Vickers, James, 5602 BS Eindhoven (NL); Somani, Seema, 5602 BS Eindhoven Noord-Brabant (NL); Campochiaro, Cecelia, 5602 BS Eindhoven Noord-Brabant (NL); Bobrov, Yakov, 5602 BS Eindhoven Noord-Brabant (NL)
(74) Representative: Janssen, Francis-Paul

(57) **Abstract**

Described herein are a system and method of preparing integrated circuits (ICs) so that the ICs remain electrically active and can have their active circuitry probed for diagnostic and characterization purposes using charged particle beams. The system employs an infrared camera capable of looking through the silicon substrate of the ICs to image electrical circuits therein, a focused ion beam system that can both image the IC and selectively remove substrate material from the IC, a scanning electron microscope that can both image structures on the IC and measure voltage contrast signals from active circuits on the IC, and a means of extracting heat generated by the active IC. The method uses the system to identify the region of the IC to be probed, and to selectively remove all substrate material over the region to be probed using ion bombardment, and further identifies endpoint detection means of milling to the required depth so as to observe electrical states and waveforms on the active IC.

## Description

### FIELD OF THE INVENTION

This invention relates to the diagnosis and characterization of electrically active integrated circuits using charged particle beams, and to the probing of electrical activity from the backside of modern integrated circuitry while said circuitry is being electrically stimulated. More specifically, the invention describes techniques that can be added to a charged-particle microscope system to enable high-speed waveform probing.

### BACKGROUND OF THE INVENTION

Integrated Circuits (ICs) undergo electrical device characterization throughout their design and manufacturing life cycle to verify that the ICs are meeting their performance expectations. An IC not meeting design performance expectations may undergo a debugging and failure analysis process to determine the root cause of its non-conformance. The field of electrical failure analysis involves the diagnosis and characterization of electrically active IC devices for the purpose of identifying the root cause of such non-conformances.

### BRIEF DESCRIPTION OF THE DRAWINGS

Figure 1A is an example charged particle beam system in accordance with an embodiment of the present disclosure.
Figure 1B is an example IC in accordance with an embodiment of the present disclosure.
Figure 2 is a flow chart of an example method in accordance with an embodiment of the present disclosure.
Figure 3 is an example functional block diagram in accordance with an embodiment of the present disclosure.

Like reference numerals refer to corresponding parts throughout the several views of the drawings.

### DETAILED DESCRIPTION OF EMBODIMENTS

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatus' are referred to as "lowest", "best", "minimum," or the like. It will be appreciated that such descriptions are intended to indicate that a selection among many used functional alternatives can be made, and such selections need not be better, smaller, or otherwise preferable to other selections.

The current state of the art in electrical device characterization uses optical lasers focused on individual transistors within an IC to measure electrical activity within an active IC. See for example Kindereit, Ulrike, "Fundamentals and Future Applications of Laser Voltage Probing", IEEE Reliability Physics Symposium, pp. 1-11, Jun. 2014. A limitation of optical probing techniques, however, is that they are unable to resolve features substantially smaller than the wavelength of the light used in the optical probe, and despite a recent push to shorten the wavelength and use visible optical probing techniques (see, for example, U. S. Patent 9,651,610 B2), the feature sizes of advanced ICs have now shrunk well beyond the limit that optical diagnostic tools can resolve. A renewed interest therefore exists for diagnostic tools that derive their imaging resolution from charged particle beams that can resolve features much smaller than optical wavelengths.

Diagnostic tools able to perform electrical device characterization of ICs using charged particle beams have existed for several decades. For example, U. S. Patent 4,706,019 filed in 1985 discloses an electron beam test probe system for analyzing ICs from their front side. During the 1990s, however, advanced ICs became packaged in a "flip-chip" state where access to the front active side of an active IC was no longer possible, and this advance in packaging led to a need to probe ICs from their back substrate side. U. S. Patent 5,972,725 (hereafter '725) discloses a method of precisely measuring electrical parameters from the back substrate side of an IC by using a scanning electron microscope probe directed at active regions of the IC exposed by the removal of the semiconductor substrate. U. S. Patent 6,872,581 (hereafter '581) discloses a method of probing active ICs from their back substrate side using charged particle beams - electron or ion beams - directed at a thinned substrate layer where electrical activity beneath the thinned substrate layer induces an electrical potential on the outer surface that is probed by the charged particle beam. Thus '725 teaches a method of using a scanning electron microscope to measure electrical activity from the backside of an IC by thinning the substrate all the way to the active regions of the IC, while '581 allows that either an electron or an ion microscope can probe electrical activity from a surface near, but not at, the active regions of the IC.

Two challenges present themselves when attempting to measure high-speed waveforms with charged particle techniques, namely the transit time spread (TTS) of the secondary electrons as they travel from their origin to an electron detector, and second, the temporal response of the electron detector itself.

As an example, in either an ion or electron microscope, uniformly energetic charged particles are focused onto a region to be imaged, which is commonly referred to as the Device Under Test (DUT), which can include a single transistor, a circuit of several transistors, several circuits, or a metal trace, to name a few. Since all particles in the charged particle beam have similar energies, they travel through the microscope column in nearly identical time. Once the charged particles strike the DUT, they cause secondary electrons to be ejected from the DUT, and for each charged particle that bombards the DUT, approximately one secondary electron becomes ejected as a secondary electron. The secondary electrons emitted by the DUT are typically captured via some detection means, and the intensity of this secondary electron signal is used to create the image in a charged-particle microscope.

Although the charged particles striking the DUT in an ion or electron microscope have nearly identical energies, the same cannot be said for the secondary electrons that are emitted/ejected from the DUT. Such secondary electrons can have an energy anywhere from just above zero electron volts up to the energy of the incoming beam. Since the secondary electrons can have such a large spread in energies, they necessarily have a large spread in ejected velocities. An ejected secondary electron with very little energy will take a relatively longer time to travel to an electron detector, while an ejected secondary electron with more energy will take a relatively shorter time to travel to the same electron detector. This variation in time for the various-energy electrons to transit between their origin (the DUT) and the detector is known as the TTS of the secondary electrons. TTS leads to a smearing in time of secondary electron arrivals at the detector. For instance, it is entirely possible that a high energy secondary electron ejected from the DUT at a later time than a low energy secondary electron could arrive at the electron detector first. This TTS lowers the achievable frequency bandwidth of any signal derived from secondary electron emission.

The temporal response of the electron detector further limits the achievable bandwidth of any measurement derived from secondary electron emission. A typical electron detector consists of an accelerating electric field that pulls electrons towards the detector. The accelerated electrons impinge upon a phosphor, leading to a cascade of photons being emitted from the phosphor as a result of the electron impingement. A typical phosphor may emit such photons with an exponential decay time of several tens of microseconds, and this stochastic process further reduces the achievable bandwidth of the detector. These photons are then directed at a Photomultiplier Tube (PMT), which converts the photons back into a pulse of electrons, and this electron multiplication process also comes with its own TTS.

Taken together, the variations in electron transit time of the secondary electrons, plus the inherent limitations of the electron detector, limit the achievable frequency bandwidth of any signal that we derive from the secondary electrons. Typical detectors may have a bandwidth of only 5 MHz as a result of these effects, though it may be possible to increase this bandwidth with alternate detector designs. Nevertheless, it remains unlikely that any detector design could operate at gigahertz speeds typical of modern ICs, and as a result some other method is required to achieve high-speed waveform capture from a modern DUT.

As an example of the limitations imposed by the secondary electron detector bandwidth, consider the case of shining a charged-particle beam of constant intensity at a substrate whose potential varies at a fixed frequency. In this example the substrate targeted by the charged particle beam might be a transistor inside an active integrated circuit that is being driven by a periodic signal, e.g., a clock signal. A mechanism known as voltage contrast, which can be observed using charged particle microscopy, causes the secondary electron emission rate to vary with the potential of the region being illuminated by the charged-particle beam, and it is well known that less secondary emission is observed from a region being illuminated by the charged-particle beam as that region's potential increases. As a result, the waveform being probed appears, in negative form, in the intensity of the secondary electrons. If, in this example, the transistor being probed is clocking at a 1 MHz rate, and the secondary electron detector is bandwidth limited to 5 MHz, it is possible to observe the 1 MHz transistor clocking frequency coming from the detected secondary emission. However, if in this example the transistor being probed is clocking at 1 GHz, the secondary electron detector will not be able to detect this frequency. To measure transistors clocking at 1 GHz, a technique of measuring such signals that occur at frequencies above the bandwidth limitation of the secondary electron detector is disclosed herein.

The '581 and '725 patents teach methods of stroboscopically illuminating the DUT with short pulses of electrons. The electron beam in the scanning electron microscope is very rapidly turned on and off, leading to short pulses of electrons exiting the electron source. Because electrons travelling toward the DUT through the electron microscope all have similar energies, there is very little TTS - i.e. pulse broadening - of this beam before it strikes the DUT. If the pulse rate of these electrons is kept well below the measurement bandwidth of the electron detection, then the achievable bandwidth of such a strobed system is no longer limited by the TTS of the secondary electrons, or of the detector itself, but rather by the duration of the electron pulse arriving at the DUT. Previous iterations of electron beam probing systems available in the late 1990s were able to achieve 50 picosecond pulse times and could measure waveforms from DUTs with over 5 GHz bandwidth, however a limitation of these systems was that only one electron probe pulse could be measured per tester cycle, and this limitation greatly increased the required acquisition times.

Disclosed herein are techniques for synchronizing fast pulses with an electron beam probe system to enhance the bandwidth of electrical signals or waveforms that can be measured in the presence of a limited-bandwidth secondary electron detector. The disclosed techniques reduce or remove the limitations imposed by a relatively low-bandwidth electron detection system and enable high-bandwidth measurements of electrical activity on active integrated circuitry.

The method of synchronizing fast pulses with an electron probe system may use either photons, electrons, or ions as the source of the fast pulses. For photons, fast pulses could be provided by switched laser sources, pulse-on-demand laser sources, or mode-locked lasers having picosecond or even femtosecond pulse durations, to name a few, but the list is not intended to be exhaustive. For charged particles, fast pulses could be provided by high speed beam blanking techniques that switch the signal source on and off in electron and ion microscopes, high speed beam deflection techniques capable of moving the charged particle beam on and off a particular region, or photogenerated charged particle pulses created as a result of a fast optical pulse, to name a few, but the list is not intended to be exhaustive. The precise method of creation of such fast pulses is not relevant for this disclosure, and those skilled in the art will understand that many such means exist to create these pulses. Instead, it is the synchronization of these fast pulses with electrical activity on the DUT for the purpose of improving the electrical measurement bandwidth using charged particle beams that is of interest in this disclosure.

A method for synchronizing optical pulses from a mode-locked laser with a periodic electrical trigger, for instance a trigger sourced by semiconductor automated testing equipment (ATE), is disclosed by the present inventor in U. S. Patent 9,201,096. The method disclosed in said patent takes advantage of microscopic adjustments that can be introduced into the optical cavity of the mode-locked laser to change the repetition rate of its output pulses. For instance, commercially available mode-locked lasers can output pulses of light at 100 MHz with a tunability of 50 ppm, which in this example corresponds to laser pulses at a tunable rate covering 100 MHz +/- 5 kHz. It is presumed that the periodic electrical trigger coming from the ATE cannot be adjusted, so instead the pulse rate of the mode-locked laser is adjusted until an exact integer number of laser pulses fits into one period of the ATE trigger.

As an explicit example, if a test period generated by an ATE system is 100,002.3 nanoseconds (approximately, but not exactly, 10 kHz), it will not be possible to synchronize a mode-locked laser running at 10.0 ns period with the ATE system. However, if the pulses of the mode-locked laser can be stretched from 10.0 ns to 10.00023 ns, which is only a 23 part per million increase, then by doing so you can now squeeze exactly 10,000 laser pulses in each ATE period, and the mode-locked laser pulses will now be completely synchronized with the ATE period.

U. S. Patent 9,201,096 also teaches a method of adjusting the relative position between the ATE period and the pulses of light coming from the mode-locked laser. Once the pulses from the mode-locked laser are synchronized with the ATE period, the pulses of light will always occur at the exact same offset time within each ATE period, and by adjusting the relative position between the ATE period and the pulses of light it is possible to place a pulse of light from the mode-locked laser at any precise time desired within the ATE tester period, and have it remain there until commanded otherwise. For example if you wish to place a pulse of light at any time offset within an ATE period, you may adjust the mode-locked laser using the methods described to achieve precisely this outcome.

The following describes a method and apparatus for collecting electrical signals or waveforms from active integrated circuitry that enables the frequency bandwidth of the collected electrical signals or waveforms to exceed the frequency bandwidth of the secondary charged particle detector that collects such signals or waveforms. Described herein are several embodiments to achieve this goal, but the methods described herein should not be restrictive as those skilled in the art will understand that various modifications to the process may be made without departing from the spirit of this disclosure. For instance, although we envision this technique being applied to measuring waveforms from active circuitry inside an integrated circuit using an electron beam as the probe of electrical activity, the techniques described herein are equally applicable to optical, electron, and ion microscopes, or to measuring any high-speed signal using charged particles.

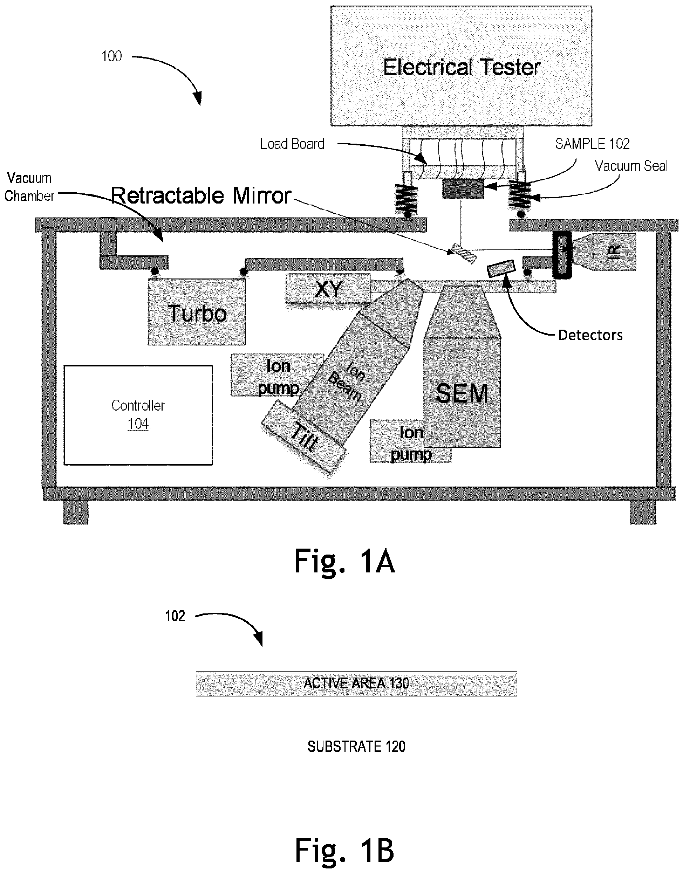

Figure 1A is an example charged particle beam system 100 in accordance with an embodiment of the present disclosure. The system 100 may be a dual-beam system, as known in the art. For example, the system 100 may include both an electron beam column and an ion beam column. The column labeled SEM may include an electron emitter, such as a Schottky emitter, various lenses for focusing the electron beam, and detectors. The detectors may be used to detect backscattered and secondary electrons, for example, but other photon-centric detectors may also be included, such as ultraviolet, visible, and infrared light detectors and/or x-ray detectors. The ion beam column, labeled as such in Figure 1A, includes an ion source, such as a plasma or liquid metal ion source, along with focusing optics for shaping the ion beam. The detectors discussed above in relation with the SEM column may also be used in conjunction with the ion beam column. For example, secondary electrons and/or secondary ions may be detected when the sample is subject to an ion beam.

The system 100 further includes an infrared imaging system for locating regions of interest in the active area of the sample 102. The regions of interest are areas where one or more transistors, e.g., finFETs, are to be analyzed. Locating the one or more transistors helps the system 100 navigate to the area that requires additional processing to expose the regions of interest. The infrared imaging system at least includes a retractable mirror and an infrared camera, labeled IR in Figure 1A. Additionally (and not shown), the infrared imaging system includes a suitable IR source for projecting IR light through a sample and towards the retractable mirror.

The system 100 also includes an electrical tester that can be coupled to an IC under test (e.g., sample 102), which may also be referred to as a device under test (DUT). The electrical tester may provide clock and/or data signals to one or more functional blocks of the IC device to drive the transistors of the functional block. One or more of the transistors of a designated area, e.g., region of interest, may desirably be examined for failure mechanisms, and which may be excavated by ion milling, for example, for specific testing. The excavation of the transistors may be performed as disclosed herein.

The system 100 also includes other ancillary equipment for producing a low pressure environment required for operating the ion beam and SEM columns. For example, a vacuum seal may seal the sample 102 and electrical tester to the SEM column, ion beam column, and infrared imaging system. To generate the low pressure/high vacuum environment, the system 100 includes a turbo pump, and one or more ion pumps, all coupled to the vacuum chamber. A stage may be included in the vacuum chamber to manipulate the location of the ion beam and SEM columns, the sample 102, or both. The stage may be moved in at least three degrees of freedom, but additional degrees may also be included allowing for both translational and rotational movement.

Additionally, the system 100 includes a controller coupled to the ion beam column, the SEM column, the detectors, the infrared imaging system, the electrical tester, and the vacuum pumps. The controller is coupled to control operation of the various components for implementing the techniques disclosed herein. For example, the method 200, discussed in detail below, may use the SEM column and the ATE to electrically test the sample 102. Specifically, the method 200 may include defining various clock frequencies for driving the sample, ATE, and SEM column along with phase locking the clock frequencies for providing a charged particle beam to the sample 102 at a derivative frequency of the phase locked loop frequencies.

The sample 102, which may be thermally managed, is coupled to a load board. The load board is coupled to the electrical tester, and the sample 102. The load board relays electrical test signals from the electrical tester to the sample 102. Figure 1A shows an example location for the load board. In other embodiments, the load board may be on the bottom side of the sample 102. In some embodiments, the load board may be used for coupling the vacuum chamber to the electrical tester and may include at least two dimensional alignment mechanics. In some embodiments, the load board may include heat sinking and heat exchange aspects to remove heat from the sample 102. For example, the load board may include a fluid heat exchanger or a thick copper plane, but other techniques may also be implemented.

Figure 1B is an example IC 102 in accordance with an embodiment of the present disclosure. The IC 102, which may also be simply referred to as sample 102, includes a substrate 120 and an active area 130. The substrate 120 may be formed from any known semiconductor material, such as silicon, GaAs, InP, Ge, GaN, etc. While silicon is used to illustrate the disclosure, the disclosure is not limited as such. The active area 130 may include one or more levels of active circuitry, such as transistors coupled by metal traces. In some examples, the transistors are finFETs, as discussed herein. However, while the disclosed processing techniques may be advantageous for finFET processing, the techniques are not limited by the transistor technology. As used herein, a backside of the sample 102 is the substrate side whereas a front side of the sample 102 is the active area 130 side.

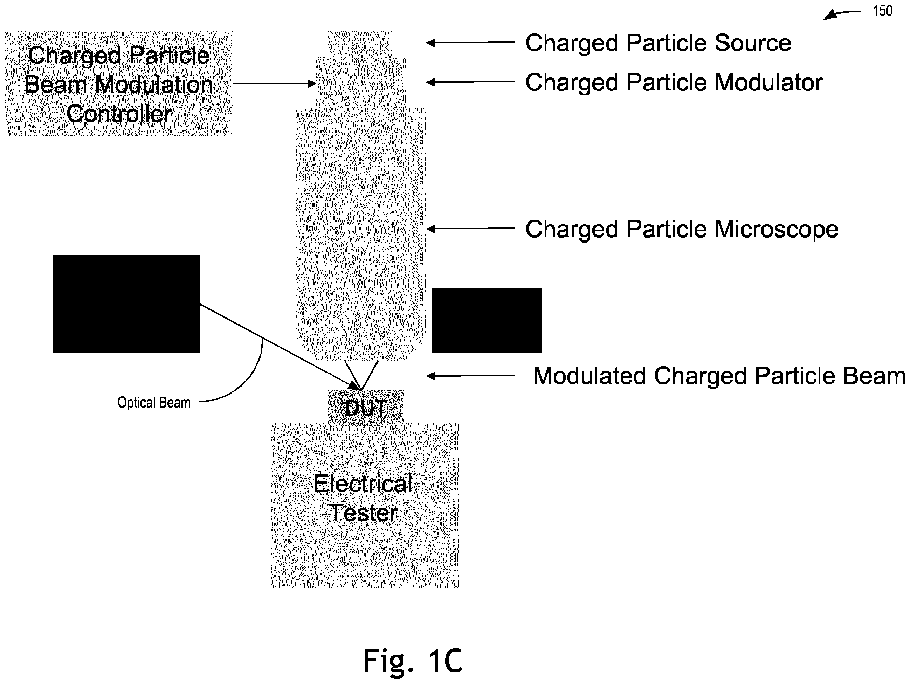

Figure 1C is an example illustration of a portion 150 of the system 100 in accordance with an embodiment of the present disclosure. The portion 150 includes an SEM column (labeled charged particle microscope in Figure 1C), a modulation controller, an electrical tester, and an optical source. The portion 150 may provide a modulated charged particle beam to the DUT coupled to the electrical tester for collecting electrical signals or waveforms from active integrated circuitry that enables the frequency bandwidth of the collected electrical signals or waveforms to exceed the frequency bandwidth of the secondary charged particle detector that collects such signals or waveforms.

The portion 150 illustrates the charged particle beam modulation controller, which may be the controller 104 or coupled to the controller 104. The modulation controller may be coupled to the charged particle modulator to control modulation of the charged particle beam provided by the charged particle source. For example, the charged particle modulator may include beam blankers that shutter the charged particle beam provided by the charged particle source. However, other techniques now known and developed in the future are contemplated herein.

The charged particle microscope, which may be based on electrons or ions, for example, then provides, e.g., focuses, the modulated charged particle beam onto the DUT of the sample 102. Additionally, an optical source may provide an optical beam to the DUT and coincident with the modulated charged particle beam incident on the DUT. In some embodiments, the optical source may provide fast pulses, which could be provided by switched laser sources, pulse-on-demand laser sources, or mode-locked lasers having picosecond or even femtosecond pulse durations.

As discussed herein, the DUT is provided electrical test signals from the electrical tester while being probed by the modulated charged particle beam and/or the optical beam. As the DUT is being probed by the electrical tester and the charged particle beam, the detector may be receiving secondary electrons from the DUT. Due to potential changes of the DUT due to concurrence of the electrical test signal and the modulated charged particle beam, the detector may be able to distinguish the electrical signals operation of the DUT. As noted, the charged particle beam may be acting as a probe due to the nanometer size of the DUT, e.g., a fin of a finFET.

One embodiment of the present invention uses beam-blanking technology included with the SEM column to cycle the charged-particle beam on and off with a fixed pattern and a fixed repetition rate that is phase locked to, or purposely synchronized with, the operation of the active circuitry on the DUT being probed by the electrical tester. One implementation includes turning the beam on and off at a fixed source frequency, F_{S}, having a 50% on/off duty cycle, but other duty cycles, or arbitrary pulse waveforms, are also be considered.

Consider the case of using a continuous charged-particle beam to probe a clock signal at a frequency F_{C} that is above the secondary electron detector bandwidth F_{SE}. The charged particle beam may be provided by either the SEM column or the ion beam column. As described earlier, this signal will not be observed by the detector because F_{C>}F_{SE}. However, if instead of using a continuous charge-particle beam you used the chopped charged-particle beam at frequency F_{S} as described in the previous paragraph, then as long as |N*F_{S} - F_{C}| < F_{SE}, where N is any integer, the clock signal at frequency F_{C} will be aliased by the charge-particle sampling beam at frequency F_{S} to be within the detectable frequency bandwidth of the detector, F_{SE}. One example would be to probe an F_{C} = 1 GHz clock being provided to the DUT with a charged-particle beam chopped at frequency F_{S} = 1.001 GHz, which would result in a 1 MHz aliased signal that the secondary electron detector of the SEM column could detect. As a more complex example, the same 1 GHz clock could be probed with a charged-particle beam of the SEM column chopped at frequency F_{S} = 100.1 MHz, which would also result in a 1 MHz aliased signal that the secondary electron detector could detect (because integer N = 10 satisfies as |N*F_{S-}F_{C}| < F_{SE}). A person skilled in the art of signal processing will recognize other embodiments using arbitrary periodic charged-particle pulses to correlate with expected DUT electrical waveforms to create a similar aliased outcome.

In the preceding paragraph, the fixed source frequency F_{S} must be purposely chosen to relate to the known clock frequency F_{C} and detector bandwidth F_{SE} to guarantee the condition |N*F_{S-}F_{C}| < F_{SE} so that the clock signal provided to the DUT can be measured using the charged-particle probe system of system 100. The source frequency F_{S} can be derived from a free-running oscillator, or more commonly, will be generated through a routine phase-locked-loop technique to be synchronized with the clock F_{C}. In some embodiments, the controller 104 may provide the source frequency based on the frequency of the electrical signals provided by the electrical tester and formed to satisfy the above relationship between N, F_{S}, F_{C}, and F_{SE}.

A second embodiment of the present disclosure includes generating a single pulse of charged particles by the SEM column for every test cycle provided by the electrical tester, and phase locking the pulse to the tester cycle so that the pulse always occurs at the same relative time offset location within the tester cycle. In this the DUT waveform is sampled during each ATE test cycle, and the fact that the secondary electron detector bandwidth is slow may not be an issue. In this embodiment, the maximum measurement bandwidth is determined by the duration of the charged particle beam pulse, with an approximate formula for the waveform bandwidth frequency (F_{W}) limit given by F_{W} = 0.4 /T_{PULSE}, where T_{PULSE} is the full width duration, in seconds, of the pulse of charged particles striking the DUT. As an example, a charged particle pulse of duration T_{PULSE} = 1 ns can adequately sample DUT waveforms up to a bandwidth of 400 MHz.

A third embodiment of the present disclosure includes using optical light and the charged particle beam in conjunction with the electrical test signals. Such an embodiment includes generating a single pulse of optical light, phase locked to the test cycle provided by the electrical tester, and directing that pulse of light to strike the DUT at the same time and location as the charged particle beam is incident on the DUT. It has been observed that optical energy directed at a surface being probed by charged particle beams causes the secondary emission rate to increase. Thus, the optical beam is used as a means of increasing the secondary emission rate in such a way that the overall bandwidth of the waveform measurement derives its timing from the optical pulse, which can be picoseconds or even femtoseconds, rather than from the pulse duration of the charged particle beam. In this manner a relatively broad (in duration) charged particle beam could strike the DUT, and the secondary electron return could be augmented during a fast optical pulse, such that the secondary electron signature measured is at least partially, if not primarily, formed as a snapshot of the voltage waveform on the DUT when the optical beam arrived. Using techniques described in U. S. Patent 9,201,096, the optical beam could be swept through the duration of the longer charged-particle pulse to measure electrical waveform off of an active IC DUT with a bandwidth, determined by the time duration of the optical pulse, that greatly exceeds the bandwidth of either the beam blanking technology or the secondary detector technology.

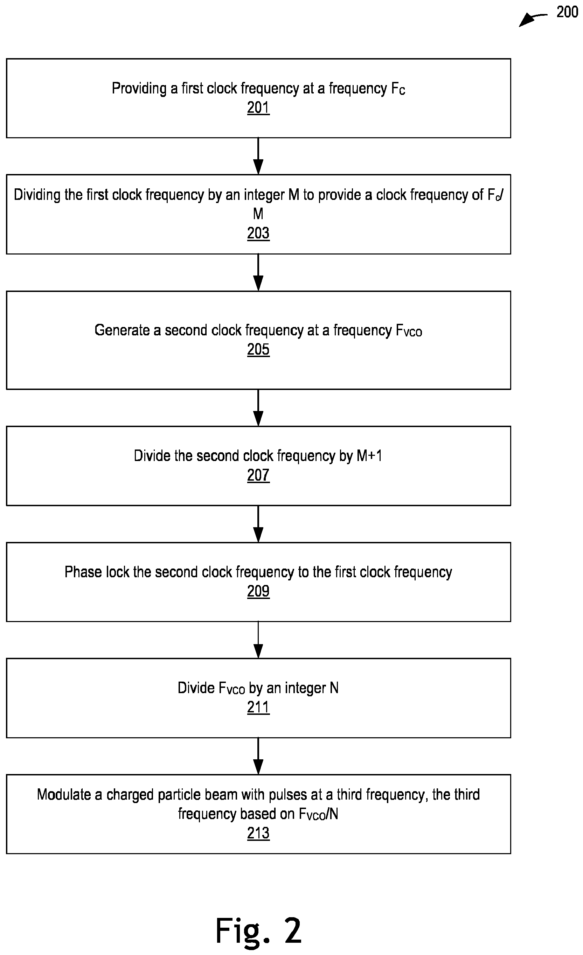

Figure 2 is an example method 200 in accordance with a disclosed embodiment. The method 200 may be implemented by the system 100, for example, to probe a DUT on the sample 102. The method 200 includes a technique for collecting electrical signals or waveforms from active integrated circuitry that enables the frequency bandwidth of the collected electrical signals or waveforms to exceed the frequency bandwidth of the secondary charged particle detector that collects such signals or waveforms.

The method 200 may begin with process block 201, which includes providing a first clock frequency at a frequency of Fc. For example, the first clock frequency may be provided by the electrical tester of system 100 to the controller 104. The first clock frequency may be the frequency of the electrical test signals the electrical tester is providing to the sample 102, for example.

The process block 201 may be followed by the process block 203, which includes dividing the first clock frequency by an integer M. As a result, the frequency of the first clock frequency becomes F_{C}/M. Integer M may be chosen such that F_{C}/M is less than the bandwidth limit of the secondary electron detector of the system 100. The bandwidth of the secondary electron detector may be F_{SE}. Accordingly, M may be chosen so that F_{C}/M < F_{SE}.

The process block 203 may be followed by the process block 205, which includes providing a second clock frequency. For example, the second clock frequency may be generated by the controller 104 using a variable/adjustable voltage controlled oscillator, or any other technique. The second clock frequency, for ease of description, may be referred to as F_{VCO}, but such designation is not limiting on the source of the second clock frequency.

The process block 205 may be followed by the process block 207, which includes dividing the second clock frequency by an integer M+1. The controller 104 may digitally divide the second clock frequency accordingly.

The process block 207 may be followed by the process block 209, which includes phase locking the second clock frequency to the divided first clock frequency. For example, the phase locking may include causing the divided first clock frequency F_{C}/M to equal F_{VCO}/(M+1). Once phase locked, FCVO may equal F_{C} + F_{C}/M.

The process block 209 may be followed by process block 211, which includes dividing F by an integer N. See above discussion regarding the condition |N*F_{S-}F_{C}| < F_{SE} so that the clock signal provided to the DUT can be measured using the charged-particle probe system of system 100. If N is chosen to be or becomes 1, then this process block may be omitted.

The process block 211 may be followed by the process block 213, which includes modulating the charged particle beam provided by the SEM column at a frequency of F_{VCO}/N.

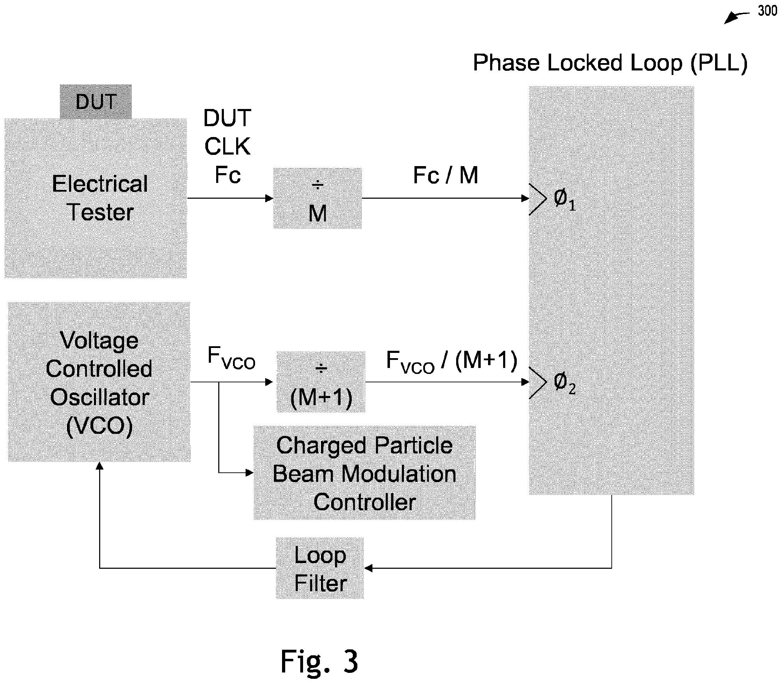

Figure 3 is an example functional block diagram 300 in accordance with an embodiment of the present disclosure. The functional block diagram may be an illustration of various components of the system 100 used for implementing the method 200. Other than the DUT and the electrical tester, the various components show in Figure 3 may be part of the controller and/or the SEM column. The functional block diagram 300 includes

The electrical tester may be coupled to provide electrical test signals to the DUT at a first frequency, such as F_{C}. The frequency of the electrical test signals may also be provided to a divider, which may be a digital divider. The divider may, in turn, provide a derivative of the first frequency to a phase locked loop (PLL). The derivative frequency may be F_{C} divided by an integer M. Integer M may be chosen such that F_{C}/M is less than the bandwidth limit of the secondary electron detector of the system 100. The bandwidth of the secondary electron detector may be F_{SE}. Accordingly, M may be chosen so that FC/M < F_{SE}.

A voltage controlled oscillator, VCO, may generate a second frequency F_{VCO}. In some embodiments, the VCO may able to adjust F_{VCO} as directed by the controller 104, for example. The second frequency is provided to a second divider, which may also be a digital divider, which may provide a derivative of the second frequency. In some embodiments, the derivative of the second frequency may be F_{VCO} divided by (M+1). The frequency F_{VCO} may additionally be provided to a charged particle beam modulation controller for modulating a charged particle beam based on F_{VCO}. The derivative of the second clock frequency may be also be provided to the PLL.

The PLL may then lock the derivative of the second clock frequency to the derivative of the first clock frequency by providing a control signal to the VCO through a loop filter. Thus, by locking the modulating frequency of the charged particle modulation controller to the first clock frequency provided by the electrical tester, fluctuations in secondary charged particles emitted by the DUT may be detectable by the secondary electron detector regardless of its bandwidth limitations.

Having described and illustrated the principles of the disclosed technology with reference to the illustrated embodiments, it will be recognized that the illustrated embodiments can be modified in arrangement and detail without departing from such principles. For instance, elements of the illustrated embodiments shown in software may be implemented in hardware and vice-versa. Also, the technologies from any example can be combined with the technologies described in any one or more of the other examples. It will be appreciated that procedures and functions such as those described with reference to the illustrated examples can be implemented in a single hardware or software module, or separate modules can be provided. The particular arrangements above are provided for convenient illustration, and other arrangements can be used.

In view of the many possible embodiments to which the principles of the disclosed technology may be applied, it should be recognized that the illustrated embodiments are only representative examples and should not be taken as limiting the scope of the disclosure. Alternatives specifically addressed in these sections are merely exemplary and do not constitute all possible alternatives to the embodiments described herein. For instance, various components of systems described herein may be combined in function and use. We therefore claim all that comes within the scope of the appended claims.

## Claims

1. A method to measure electrical activity in an IC, the method comprising:
electrically activating the IC at a first frequency;
directing a charged particle beam at a probe location on the IC;
modulating the charged particle beam at a second frequency, the second frequency different than the first frequency; and
detecting secondary electrons emitted from the probe location due to the charged particle beam, wherein due to the modulation of the charged particle beam, the secondary electrons are within a bandwidth of a detector receiving the secondary electrons.

2. The method of claim 1, wherein the first frequency is out of bandwidth for the detector and/or wherein the second frequency is out of bandwidth for the detector.

3. The method of claim 1 or 2, further comprising phase locking the second frequency to the first frequency.

4. The method of claim 3, wherein phase locking the second frequency to the first frequency comprises;
phase locking a derivative of the first frequency and a derivative of the second frequency; and
providing feedback to a voltage controlled oscillator providing the second frequency based on the phase locking of the derivatives.

5. The method of claim 4, wherein the derivative of the first frequency is different than the derivative of the second frequency.

6. The method of claim 1-5 further including;
directing an optical beam on probe location coincident with the modulated charged particle beam.

7. The method of claim 1-6, wherein electrically activating the IC at a first frequency includes driving the IC with a test signal based on the first frequency.

8. The method of claim 7, wherein the charged particle beam is modulated such that a single pulse is directed toward the IC during a single test signals.

9. A system comprising:
an electron beam column coupled to provide an electron beam;
electron beam modulators coupled to modulate the electron beam in response to a control signal;
a detector to detect secondary electrons; and
a controller at least coupled to the electron beam column, electron beam modulators, and the detector, the controller configured to:
electrically activate the IC at a first frequency;
direct a charged particle beam at a probe location on the IC;
modulate the charged particle beam at a second frequency, the second frequency different than the first frequency;
detect secondary electrons emitted from the probe location due to the charged particle beam, wherein due to the modulation of the charged particle beam, the secondary electrons are within a bandwidth of a detector receiving the secondary electrons.

10. The system of claim 9, wherein the first frequency is out of bandwidth for the detector and/or wherein the second frequency is out of bandwidth for the detector.

11. The system of claim 9, wherein the controller is further configured to phase lock the second frequency to the first frequency.

12. The system of claim 11, wherein to phase lock the first and second frequencies, the controller is configured to:
phase lock a derivative of the first frequency and a derivative of the second frequency; and
provide feedback to a voltage controlled oscillator providing the second frequency based on the phase locking of the derivatives.

13. The system of claim 12, wherein the derivative of the first frequency is different than the derivative of the second frequency.

14. The system of claim 9-13, wherein the controller is further configured to direct an optical beam on probe location coincident with the modulated charged particle beam.

15. The system of claim 9-14, wherein to electrically activate the IC at a first frequency includes driving the IC with a test signal based on the first frequency, and in particular wherein the charged particle beam is modulated such that a single pulse is directed toward the IC during a single test signals.
